# EUROPEAN PATENT APPLICATION

(11) **EP 4 716 237 A1**
(43) Date of publication of application: **25.03.2026**
(21) Application number: 23962962.9
(22) Date of filing: 29.12.2023
(51) Int. Cl.: H04R 1/10

(54) **ACOUSTIC MODULE AND ACOUSTIC DEVICE**

(71) Applicant: Shenzhen Shokz Co., Ltd., Shenzhen, Guangdong 518108 (CN)
(72) Inventor: ZHOU, Wenbing, Shenzhen, Guangdong 518108 (CN); HUANG, Yujia, Shenzhen, Guangdong 518108 (CN); KE, Hao, Shenzhen, Guangdong 518108 (CN); ZHANG, Henghao, Shenzhen, Guangdong 518108 (CN); LIAO, Fengyun, Shenzhen, Guangdong 518108 (CN); QI, Xin, Shenzhen, Guangdong 518108 (CN)
(74) Representative: Wang, Bo
(86) International application number: PCT/CN2023/143683
(87) International publication number: WO 2025/138289

(57) **Abstract**

The present disclosure provides an acoustic module and an acoustic device, and relates to the technical field of electronic devices. The acoustic module includes a base, a first waterproof assembly, and a first acoustic assembly. The base includes a base sidewall, a base bottom wall, and a first sound guiding hole. The base sidewall and the base bottom wall form a first accommodation cavity, and the first sound guiding hole penetrates the base bottom wall and communicates with the first accommodation cavity. The first waterproof assembly is disposed within the first accommodation cavity and covers the first sound guiding hole to prevent liquid from entering the first accommodation cavity through the first sound guiding hole. The first acoustic assembly includes a first acoustic transducer and a first circuit board. The first acoustic transducer is disposed on a side of the first waterproof assembly away from the base bottom wall, and the first circuit board is disposed between the first acoustic transducer and the first waterproof assembly and is mechanically connected to the first acoustic transducer. By using the acoustic module, a sensitivity difference among different acoustic devices is kept within an error range to ensure consistency of acoustic devices.

## Description

### TECHNICAL FIELD

The present disclosure relates to the technical field of electronic devices, and in particular, relates to an acoustic module and an acoustic device.

### BACKGROUND

An acoustic device usually includes a plurality of acoustic transducers within the acoustic device, and when the acoustic device is applied in the wild or in a humid environment, liquids may easily enter an interior of the acoustic device through a sound guiding hole provided on the acoustic device. For example, when a user wears a wireless earphone in case of an underwater activity (e.g., swimming), water enters the interior of the earphone through the sound guiding hole. Therefore, there is a need to add a moisture and waterproof design to acoustic devices that operate in wet environments.

As a sensitivity of an acoustic transducer is affected during a process in which the acoustic transducer is assembled to an acoustic device, and moisture-proof and liquid-proof are required, the acoustic transducer needs to be combined with a waterproof structure to be sealed and installed in a housing, which is difficult to dismantle and adjust, and leads to that it is difficult to adjust the sensitivity of the acoustic transducer, and further difficult to ensure that a sensitivity difference among acoustic devices in a same batch is within an ideal deviation range, resulting in a lower yield rate of the acoustic devices in the same batch.

Therefore, there is a need to design an acoustic device and an acoustic module thereof, which can both solve the waterproof problem and the above problem of low yield rate of acoustic devices in the same batch.

### SUMMARY

In a first aspect, the present disclosure provides an acoustic module. The acoustic module includes a base, a first waterproof assembly, and a first acoustic assembly. The base includes a base sidewall, a base bottom wall, and a first sound guiding hole. The base sidewall and the base bottom wall form a first accommodation cavity, and the first sound guiding hole penetrates the base bottom wall and communicates with the first accommodation cavity. The acoustic module includes a first waterproof assembly disposed within the first accommodation cavity and covering the first sound guiding hole to prevent liquid from entering the first accommodation cavity through the first sound guiding hole. The first acoustic assembly includes a first acoustic transducer disposed on a side of the first waterproof assembly away from the base bottom wall and a first circuit board disposed between the first acoustic transducer and the first waterproof assembly and mechanically connected to the first acoustic transducer.

In some embodiments, the first waterproof assembly includes a first waterproof membrane and a first buffer. The first buffer is provided with a first center hole, and the first buffer abuts against an edge region of the first waterproof membrane.

In some embodiments, the first waterproof assembly includes a first bonding surface and a second bonding surface. The first bonding surface is adhesive, so that the first waterproof assembly can be adhered on a bottom wall surface of the first accommodation cavity after subjected to an external pressure; and the second bonding surface is adhesive, so that the first waterproof assembly can be adhered to the first acoustic assembly when contacting the first acoustic assembly.

In some embodiments, the first circuit board abuts against a top surface of the base sidewall; the first circuit board includes a plurality of first positioning holes; and the top surface of the base sidewall is provided with a plurality of first positioning projections in a one-to-one correspondence with the plurality of first positioning holes.

In some embodiments, the first acoustic assembly further includes a reinforcement member. The reinforcement member is disposed between the first circuit board and the first waterproof assembly, and abuts against the top surface of the base sidewall. The reinforcement member includes a plurality of first positioning holes; and the top surface of the base sidewall is provided with a plurality of first positioning projections in a one-to-one correspondence with the plurality of first positioning holes.

In some embodiments, each of the plurality of first positioning projections includes a first column body and an expanded first column head, the first column body being threaded through a corresponding first positioning hole.

In some embodiments, the plurality of first positioning projections are a plurality of first thermally fused columns, the first column head being formed by deformation of a top portion of the first thermally fused column after being thermally fused.

In some embodiments, the base bottom wall is provided with a first limiting portion for coupling with a second limiting portion on an inner wall of an acoustic device when assembled to the acoustic device.

In a second aspect, the present disclosure provides an acoustic device. The acoustic device includes the acoustic module as described in any one of the first aspect and a housing assembly. The housing assembly includes a housing, a second waterproof assembly, and a second acoustic assembly. The housing includes a second accommodation cavity, a second sound guiding hole, a third accommodation cavity, and a third sound guiding hole. The second sound guiding hole penetrates the housing and communicates with the second accommodation cavity, and the third sound guiding hole penetrates the housing and communicates with the third accommodation cavity. The second waterproof assembly is disposed within the third accommodation cavity, and the second waterproof assembly is sealed to the third accommodation cavity and covers the third sound guiding hole to prevent liquid from entering the third accommodation cavity through the third sound guiding hole. The second acoustic assembly includes a second acoustic transducer, and the second acoustic assembly covers the third accommodation cavity and is disposed on a side of the second waterproof assembly away from the housing. The acoustic module is mounted within the second accommodation cavity, the base is sealed to the second accommodation cavity, and the first sound guiding hole communicates with the second sound guiding hole.

In some embodiments, an inner wall of the housing forms a second accommodation sidewall and a second accommodation bottom wall of the second accommodation cavity. The second accommodation bottom wall includes a first step. The first step divides the second accommodation bottom wall into a first bottom wall and a second bottom wall, and the second sound guiding hole penetrates the first bottom wall and communicates with the second accommodation cavity.

In some embodiments, the acoustic device further includes a first sealing member. The base abuts against the second bottom wall; and a first gap is formed between the base and the first bottom wall, and the first sealing member is in the first gap and seals the first gap.

In some embodiments, the base bottom wall is provided with a first limiting portion along a circumference of the first sound guiding hole, and the first bottom wall is provided with a second limiting portion along a circumference of the second sound guiding hole. The first limiting portion and the second limiting portion mate with and abut against each other.

In some embodiments, the first sealing member is a fluid sealing material obtained by curing; and the first limiting portion and the second limiting portion mate with and abut against each other to prevent the fluid sealing material from flowing into the second sound guiding hole.

In some embodiments, the first limiting portion includes a groove disposed on the base bottom wall along the circumference of the first sound guiding hole; and the second limiting portion includes a second step disposed on the first bottom wall disposed along the circumference of the second sound guiding hole.

In some embodiments, the first limiting portion and the second limiting portion form a second gap, the second gap being sealed by the first sealing member.

In some embodiments, the base and the second accommodation cavity are sealedly connected by the first sealing member, the first sealing member being a preformed sealing gasket.

In some embodiments, a hole diameter of the second sound guiding hole in an inner wall of the housing is smaller than a hole diameter of the second sound guiding hole in an outer wall of the housing; and/or a hole diameter of the third sound guiding hole in the inner wall of the housing is smaller than a hole diameter of the third sound guiding hole in the outer wall of the housing.

In some embodiments, a center axis of the second sound guiding hole is inclined relative to a second accommodation bottom wall of the second accommodation cavity; and/or a center axis of the third sound guiding hole is inclined relative to a third accommodation bottom wall of the third accommodation cavity.

In some embodiments, the acoustic device further includes a second sealing member. An inner wall of the housing forms a second accommodation sidewall of the second accommodation cavity; and a height of the second accommodation sidewall is higher than an upper surface of the first circuit board, thereby forming an accommodating space to accommodate the second sealing member.

In some embodiments, the second acoustic assembly includes a second circuit board, the first circuit board being connected to the second circuit board and passing over the second accommodation sidewall from a target section of the second accommodation sidewall. The first circuit board is a flexible circuit board; and the target section of the second accommodation sidewall is designed more gentle compared with other portions of the second accommodation sidewall to reduce a bending degree of the first circuit board in the second accommodation sidewall.

In some embodiments, the target section includes a guiding opening and an inclined guiding surface on the second accommodation sidewall, the guiding opening being connected to the inner wall of the housing through the guiding surface to support the first circuit board.

In some embodiments, the second waterproof assembly includes a second waterproof membrane; and a second buffer provided with a second center hole. The second buffer abuts against an edge region of the second waterproof membrane.

It can be seen from the above technical solution that the acoustic device provided in the present disclosure employs an acoustic transducer mounting structure with a liquid-proof effect. As a sensitivity of an acoustic transducer is affected in a process in which the acoustic transducer is assembled to the acoustic device, and due to the requirement of moisture-proof and liquid-proof, the acoustic transducer needs to be combined with a waterproof structure to be sealed and installed in a housing, which is very difficult to dismantle and adjust, resulting in difficulty to adjust the sensitivity of the acoustic transducer, which makes it difficult to ensure that a sensitivity difference among different acoustic devices in a same batch is within an ideal deviation range, which in turn affects the yield rate of the acoustic devices. In the present disclosure, the acoustic transducer and the waterproof assembly are placed in a prefabricated acoustic module, then the acoustic module is mounted in the acoustic device, and the acoustic module adapted to the acoustic device is adjusted in accordance with the need for a preset sensitivity difference requirement, thus the sensitivity difference among a plurality of acoustic transducers in the same acoustic device can be flexibly adjusted, thereby ensuring that the sensitivity difference among the acoustic devices in the same batch is within an idea range, and ensuring the rate yield of the acoustic devices.

Other features of the acoustic device provided in the present disclosure are listed in part in the following description. Creative aspects of the acoustic device provided by the present disclosure may be fully explained by practicing or using the methods, devices, and combinations described in the detailed examples below.

### BRIEF DESCRIPTION OF THE DRAWINGS

To more clearly illustrate the technical solutions in the embodiments of the present disclosure, the accompanying drawings required to be used in the descriptions of the embodiments will be briefly described below, and it is apparent that the accompanying drawings in the following descriptions are only some of the embodiments of the present disclosure, and that, to those skilled in the art, other drawings can be obtained based on these drawings without creative labor.
FIG. 1A is a schematic diagram illustrating a structure of an acoustic device according to some embodiments of the present disclosure;
FIG. 1B is a schematic diagram illustrating an internal structure of a portion of the acoustic device according to FIG. 1A of the present disclosure;
FIG. 2A is a schematic diagram illustrating an accommodation cavity structure of a housing assembly according to some embodiments of the present disclosure;
FIG. 2B is a schematic diagram illustrating a structure of a housing assembly according to some embodiments of the present disclosure;
FIG. 2C is an A-A partial sectional view of a housing assembly according to some embodiments of the present disclosure;
FIG. 3A is a schematic diagram illustrating a shape of a second thermally fused column before being thermally fused according to some embodiments of the present disclosure;
FIG. 3B is a schematic diagram illustrating a shape of the second thermally fused column shown in FIG. 3A of the present disclosure after being thermally fused;
FIG. 4A is a schematic diagram illustrating an acoustic module mounted in a second accommodation cavity according to some embodiments of the present disclosure;
FIG. 4B is a schematic diagram illustrating an acoustic module according to some embodiments of the present disclosure;
FIG. 4C is a B-B sectional view of the acoustic module shown in FIG. 4B of the present disclosure;
FIG. 5 is a schematic diagram illustrating a structure of another acoustic module according to some embodiments of the present disclosure;
FIG. 6 is a diagram illustrating a position relationship between a second accommodation sidewall and a first circuit board according to some embodiments of the present disclosure;
FIG. 7 is a schematic diagram illustrating a second accommodation sidewall according to some embodiments of the present disclosure;
FIG. 8A is a C-C sectional view of the acoustic device shown in FIG. 1 of the present disclosure;
FIG. 8B is another C-C sectional view of the acoustic device shown in FIG. 1 of the present disclosure;
FIG. 8C is an enlarged view of part "D" shown in FIG. 8B of the present disclosure;
FIG. 9A is a line chart illustrating an acoustic transducer sensitivity under scheme A according to some embodiments of the present disclosure; and
FIG. 9B is a line chart illustrating an acoustic transducer sensitivity under scheme B according to some embodiments of the present disclosure.

### DETAILED DESCRIPTION

The following descriptions provide application-specific scenarios and requirements for the present disclosure, and are intended to enable those skilled in the art to make and use the contents of the present disclosure. Various local modifications to the disclosed embodiments are apparent to those skilled in the art and, without departing from the spirit and scope of the present disclosure, the general principles defined herein are applied to other embodiments and applications. Accordingly, the present disclosure is not limited to the embodiments shown, but rather to the broadest extent consistent with the claims.

The terminology used herein is for the sole purpose of describing particular exemplary embodiments and is not limiting. For example, unless the context clearly indicates otherwise, as used herein, the singular forms "a," "an" and "the" may also include plural forms. When used in the present disclosure, the terms "comprises," "contains," and/or "includes" means that the associated integers, steps, operations, elements, and/or assemblies are present, but does not preclude the presence of one or more other features, integers, steps, operations, elements, assemblies, and/or groups or that other features, integers, steps, operations, elements, assemblies, and/or groups may be added to the system/method.

In this application, the terms "up," "down," "left ", "right," "front," "back," "top," "bottom," "inside," "outside," "vertical," "horizontal ", "transversal," "vertical," etc. indicate an orientation or positional relationship based on the orientation or positional relationship shown in the accompanying drawings. These terms are primarily intended to better describe the present disclosure and the embodiments thereof, and are not intended to qualify that the indicated devices, elements, or assemblies must have a particular orientation, or be constructed and operated in a particular orientation.

And, some of the above terms may be used to indicate other meanings in addition to an orientation or positional relationship, e.g., the term "on" may be used to indicate a dependency or connection relationship in some cases. For example, the term "on" may also be used in some cases to indicate a dependency or connection. For those skilled in the art, specific meanings of these terms in this application should be understood according to the specific circumstances.

Additionally, the terms "mounting," "setting," "provided with," "connected to," and "communicated to," may be understood by those skilled in the art broadly. For example, the connection is a fixed connection, a removable connection, or an integral construction; a mechanical connection, or an electrical connection; a direct connection, or an indirect connection through an intermediate medium, or an internal connection between two devices, elements, or assemblies. To those skilled in the art, the specific meaning of the above terms in the present disclosure may be understood according to specific circumstances.

In the present disclosure, "X includes at least one of A, B, or C" means that X at least includes A, or X at least includes B, or X at least includes C. That is, X may include only any one of A, B, or C, or any combination of A, B, and C, as well as other possible contents/elements. The any combination of A, B, C may be A, B, C, AB, AC, BC, or ABC.

In the present disclosure, unless explicitly stated, the associative relationship arising between the structures may be a direct associative relationship or an indirect associative relationship. For example, when describing "A is connected to B," unless it is explicitly stated that A is directly connected to B, it should be understood that A may be directly connected to B, or indirectly connected to B; for example, when describing "A is above B," unless it is explicitly stated that A is directly above B (AB is adjacent to each other and A is above B), it should be understood that A may be directly above B, or indirectly above B (AB is separated by other elements and A is above B). The rest can be done in the same manner.

Considering the following description, these and other features of the present disclosure, as well as the operation and function of the associated elements of the structure, and the combination of the components and economics of manufacturing, may be significantly improved. Referring to the accompanying drawings, all of which form a part of the present disclosure. It should be clearly understood, however, that the accompanying drawings are used for illustrative and descriptive purposes only and are not intended to limit the scope of the present disclosure. It should also be understood that the accompanying drawings are not to scale.

The present disclosure is described in detail below by way of specific embodiments:

The present disclosure provides an acoustic device and an acoustic module used as an accessory in the acoustic device. By placing an acoustic transducer and a waterproof assembly in a pre-fabricated acoustic module, then installing the acoustic module in an acoustic device, and adjusting the acoustic module to be adapted for the acoustic device according to a preset sensitivity difference requirement, sensitivity differences among a plurality of acoustic transducers in a same acoustic device can be flexibly adjusted and sensitivity differences among acoustic devices in a same batch can be ensured to be within an ideal range, thereby ensuring a yield rate of the acoustic devices. The acoustic device and the acoustic module provided in the present disclosure have an anti-liquid effect. The liquid includes, but is not limited to, a liquid such as water, oil, sweat, etc. For the convenience of description, a structure of an acoustic device 01 with respect to waterproof is first described below using water as an example.

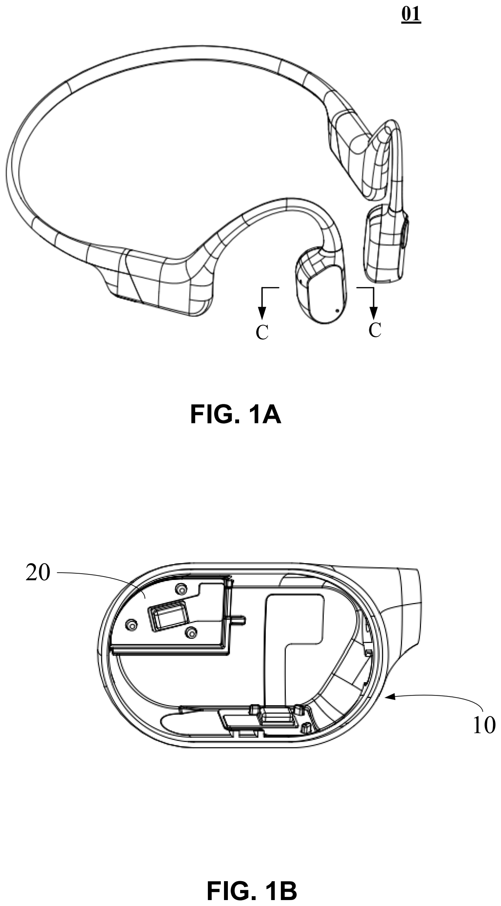

FIG. 1A is a schematic diagram illustrating a structure of an acoustic device according to some embodiments of the present disclosure. FIG. 1B is a schematic diagram illustrating an internal structure of a portion of the acoustic device according to FIG. 1A of the present disclosure. The acoustic device 01 illustrated in FIG. 1A is a wireless earphone, and the following descriptions are provided by taking the acoustic device 01 as a wireless earphone (referred to as an earphone for brevity) as an example. The earphone may be a bone conduction earphone, an air conduction earphone, or a bone and air conduction earphone. It is known that the acoustic device 01 may also be a wired earphone, a cell phone, a computer, a tape recorder, and other acoustic devices. As shown in FIG. 1B, the acoustic device 01 may include a housing assembly 10 and an acoustic module 20.

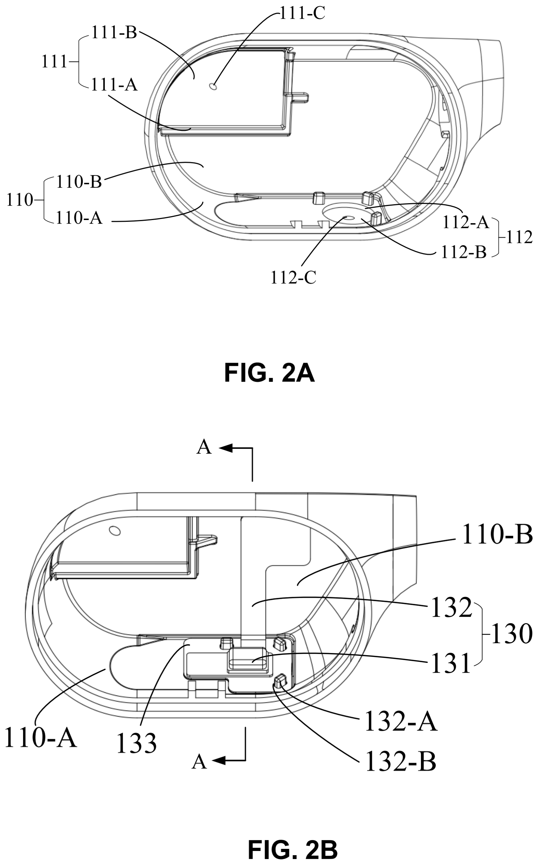

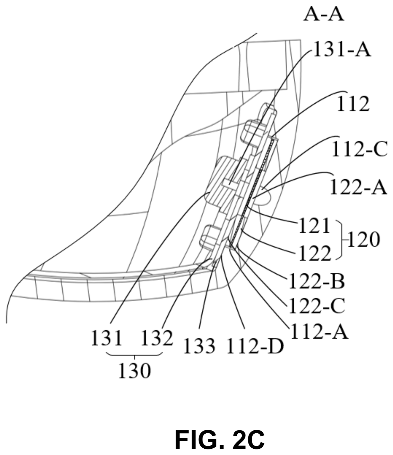

FIG. 2A is a schematic diagram illustrating a portion of an internal structure of the housing assembly 10 according to some embodiments of the present disclosure. FIG. 2B is a schematic diagram illustrating a structure of the housing assembly 10 according to some embodiments of the present disclosure. FIG. 2C is a schematic diagram illustrating an A-A partial sectional view of the housing assembly 10 according to some embodiments of the present disclosure. As shown in FIG. 2B and 2C, the housing assembly 10 may include a housing 110, a second waterproof assembly 120, and a second acoustic assembly 130.

The housing 110 may be a mounting assembly for the acoustic device 01, and other assemblies (e.g., the second waterproof assembly 120, the second acoustic assembly 130, the acoustic module 20) of the acoustic device 01 may be mounted using the housing 110 as a carrier. The housing 110 may include a housing sidewall 110-A and a housing bottom wall 110-B. The housing sidewall 110-A and the housing bottom wall 110-B together enclose an interior space where other assemblies of the acoustic device 01 are disposed. The housing 110 may be of any shape, for example, a runway shape (a rounded rectangle), circle, etc. In some embodiments, when the acoustic device 01 is a wireless earphone, the housing 110 is shaped to adapt to a contour of a human ear, allowing the wireless earphone to be fixedly worn on a user's ear. The housing 110 may be made of any material, for example, a metal, a plastic, a polymer, etc. The present disclosure does not limit the shape and the material of the housing 110. As shown in FIG. 2A, the housing 110 may include a second accommodation cavity 111 and a third accommodation cavity 112 to accommodate different assemblies.

An inner wall of the housing 110 may form a second accommodation sidewall 111-A and a second accommodation bottom wall 111-B of the second accommodation cavity 111. For example, the housing bottom wall 110-B of the housing 110 forms the second accommodation sidewall 111-A and the second accommodation bottom wall 111-B. Alternatively, the housing bottom wall 110-B forms a portion of the second accommodation sidewall 111-A and a portion of the second accommodation bottom wall 111-B, and the housing sidewall 110-A forms another portion of the second accommodation sidewall 111-A. In some embodiments, the second accommodation cavity 111 is a space enclosed by other assemblies.

The second accommodation cavity 111 may be provided with a second sound guiding hole 111-C. The second sound guiding hole 111-C may be disposed on the second accommodation bottom wall 111-B of the second accommodation cavity 111. The second sound guiding hole 111-C may pass through the housing 110 and may be in communication with the second accommodation cavity 111. In some embodiments, a hole diameter of the second sound guiding hole 111-C on an inner wall of the housing 110 is smaller than a hole diameter of the second sound guiding hole 111-C on an outer wall of the housing 110. The hole diameter herein refers to an opening diameter of the sound guiding hole on a wall surface. That is, the second sound guiding hole 111-C may be in a shape of a horn with outside wide and inside narrow. By designing the second sound guiding hole 111-C in a horn shape, on the one hand, it is easier for a user to clean foreign objects such as solid or liquid entering the second sound guiding hole 111-C, and on the other hand, it can ensure a smooth demolding during a manufacturing process of the second sound hole 111-C.

In some embodiments, a center axis of the second sound guiding hole 111-C is inclined relative to the second accommodation bottom wall 111-B, thereby preventing water from entering into the interior of the housing 110 through the second sound guiding hole 111-C. The center axis of the second sound guiding hole 111-C may be a line connecting a center of a first opening of the second sound guiding hole 111-C on the inner wall of the housing 10 and a center of a second opening on the outer wall of the housing 10. The center axis of the second sound guiding hole 111-C has an intersection point with the outer (or inner) wall of the housing 10. Taking a tangent plane at the intersection point as a reference, an inclined angle of the center axis described herein refers to an angle of the center axis relative to the tangent plane. A value of the inclined angle of the central axis of the second sound guiding hole 111-C relative to the second accommodation bottom wall 111-B may be selected according to design and processing requirements of products under the premise of not affecting an acoustic performance of the acoustic device 01. In some embodiments, the inclined angle is selected in a range of [30, 90) degrees. When the inclined angle is in a range of [60, 90) degrees, a difficulty of processing the second sound guiding hole 111-C can be reduced while ensuring a certain inclined degree. When the inclined angle is in a range of [30, 60] degrees, a resistance that resists water from entering the interior of the housing 10 through the second sound guiding hole 111-C can be improved. In some application scenarios (e.g., swimming), by setting the second sound guiding hole 111-C at the inclined angle, when the acoustic device 01 is subjected to dynamic water pressure, water flow may not directly gush into the second sound guiding hole 111-C, and the waterproof capability of the acoustic device 01 under dynamic water pressure can be improved. The second sound guiding hole 111-C may be round, oval, square, rectangular, etc., and the present disclosure does not limit the shape of the second sound guiding hole 111-C.

In some embodiments, the second sound guiding hole 111-C is an insertion hole. That is, a sound path of the second sound guiding hole 111-C is curved, resulting in that an overall shape is similar to an "L" shape. Take a bending point as a boundary, a non-zero bending angle exists between a center axis of a portion before the bending point and a center axis of a portion after the bending point. The bending angle may be 90 degrees, resulting in the "L" shape described above, or the bending angle may be an angle degree other than 90 degrees, such as an angle degree greater than 90 degrees. By designing the second sound guiding hole 111-C as the insertion hole and designing the bending angle of the second sound guiding hole 111-C, when the acoustic device 01 is subjected to dynamic water pressure, water does not directly enter the second sound guiding hole 111-C and then enter the acoustic device 01, thereby increasing a dynamic waterproof capability of the acoustic device 01.

Similarly, the inner wall of the housing 110 may also form a third accommodation sidewall 112-A and a third accommodation bottom wall 112-B of the third accommodation cavity 112. In some embodiments, the housing bottom wall 110-B of the housing 110 forms the third accommodation sidewall 112-A and the third accommodation bottom wall 112-B; or the housing bottom wall 110-B forms a portion of the third accommodation sidewall 112-A and the third accommodation bottom wall 112-B, and the housing sidewall 110-A forms another portion of the third accommodation sidewall 112-A. In some embodiments, the third accommodation cavity 112 is a space enclosed by other assemblies.

The third accommodation cavity 112 may be provided with a third sound guiding hole 112-C. For example, the third sound guiding hole 112-C is opened on the third accommodation bottom wall 112-B of the third accommodation cavity 112. The third sound guiding hole 112-C may pass through the housing 110 and communicate with the third accommodation cavity 112. The third sound guiding hole 112-C has a shape and inclined angle similar to the second sound guiding hole 111-C, which is not repeated herein.

As shown in FIG. 2A, the second accommodation cavity 111 is disposed on the housing bottom wall 110-B, and the third accommodation cavity 112 is disposed on the housing sidewall 110-A, such that the sound guiding holes in different accommodation cavities can receive or transmit sound in different directions. In some embodiments, both the second accommodation cavity 111 and the third accommodation cavity 112 are disposed on the housing bottom wall 110-A or the housing sidewall 110-B, such that the abilities of the sound guiding holes to receive or transmit sound in the same direction can be improved.

A shape of an accommodation space of the second accommodation cavity 111 and a shape of an accommodation space of the third accommodation cavity 112 may be the same. The shape of the accommodation space of the second accommodation cavity 111 and the shape of the accommodation space of the third accommodation cavity 112 may also be different. As shown in FIG. 2A, the shape of the accommodation space of the second accommodation cavity 111 and the shape of the accommodation space of the third accommodation cavity 112 are different. A cross-section of the second accommodation cavity 111 is a portion of a runway shape (a waisted circle), and a cross-section of the third accommodation cavity 112 is a circle. The shape of the accommodation space may be adapted to shape(s) of assembli(es) to be accommodated, thereby reducing consumable items of the housing 110 or other assemblies in the premising of satisfying accommodation requirements. The assemblies to be accommodated in the second accommodation cavity 111 and the third accommodation cavity 112 are described below, respectively.

As shown in FIGs. 2B and 2C, the second waterproof assembly 120 may be disposed in the third accommodation cavity 112, sealedly connected to the third accommodation cavity 112, and cover the third sound guiding hole 112-C, thereby preventing liquid (water) from entering the third accommodation cavity 112 through the third sound guiding hole 112-C and further avoiding damaging other assemblies in the housing. The second acoustic assembly 130 may be disposed on a side of the second waterproof assembly 120 away from the housing 110.

In some embodiments, the second waterproof assembly 120 includes a second waterproof membrane 121 and a second buffer 122. The second waterproof membrane 121 allows air to pass through and blocks water from passing through. The second buffer 122 may be provided with a second center hole 122-A. The second buffer 122 may abut against an edge region of the second waterproof membrane 121, for example, an edge region of a non-open region of the second buffer 122 may abut against the edge region of the second waterproof membrane 121. In some embodiments, an opening of the second center hole 122-A and an opening of the third sound guiding hole 112-C in the inner wall of the housing 110 are non-coaxial. In some embodiments, the opening of the second center hole 122-A and the opening of the third sound guiding hole 112-C in the inner wall of the housing 110 are coaxial, such that the second waterproof membrane 121 is uniformly subjected to the water pressure of the water inflow from the third sound guiding hole 112-C, thereby making the second waterproof membrane 121 less likely to be broken (which may result in a reduced waterproof effect or even failure of the second waterproof assembly 120) due to ununiform water pressure. The shape of the second center hole 122-A may be any shape such as a circle, an oval, a square, a rectangle, etc., and the present disclosure does not limit the shape of the second center hole 122-A herein. In some embodiments, the shape of the second center hole 122-A is adapted to the shape of the third sound guiding hole 112-C, and a hole diameter of the third sound guiding hole 112-C is smaller or equal to a hole diameter of the second center hole 122-A, making that the second waterproof membrane 121 has a greater area for bearing the water pressure, and further is less likely to be broken. In the present disclosure, the hole diameter refers to a diameter of the hole. In some embodiments, the hole diameter of the third sound guiding hole 112-C is 0.6 mm-1.2 mm, making the hole diameter smaller to reduce the possibility of liquid entering the housing 110 while not affecting a sound pickup capability of the acoustic device 01. In some embodiments, the hole diameter of the second center hole 122-A is 0.8 mm-1.8 mm, making the hole diameter greater to increase an area of the second waterproof membrane 121 to bear the water pressure.

In some embodiments, the second waterproof assembly 120 has a bonding surface, so that the bonding surface can be adhered to the third accommodation bottom wall 112-B after the second waterproof assembly 120 is placed in the third accommodation cavity 112, thereby realizing a sealed connection between the second waterproof assembly 120 and the third accommodation bottom wall 112-B and a fixation of the second waterproof assembly 120. For example, the second waterproof assembly 120 has a third bonding surface 122-B and a fourth bonding surface 122-C. The third bonding surface 122-B may bond the second waterproof assembly 120 within the third accommodation cavity 112 after subjected to an external pressure. The external pressure may be a gravity of the second acoustic assembly 130, or may be a pressure applied by a pressure fixture. The fourth bonding surface 122-C may enable the second waterproof assembly 120 and the second acoustic assembly 130 to be sealedly adhered when the second waterproof assembly 120 and the second acoustic assembly 130 contact each other. Specifically, the second waterproof assembly 120 may include two second buffers 122 which are respectively located on both sides of the second waterproof membrane 121. Two surfaces of the second buffer 122 facing the third accommodation cavity 112 and the second acoustic assembly 130 may be adhesive. By providing the bonding surface, the second waterproof assembly 120 is fixed in the third accommodation cavity 112 through adhesive bonding, which realizes the waterproof effect and ensures simplicity and convenience of the operation process.

Further, the second buffer 122 may also be flexible. The second buffer 122 can uniformly distribute a physical pressure (an impact energy) received by the second waterproof assembly 120, and further, during the installation of the second waterproof assembly 120, the second buffer 122 can protect the second waterproof membrane 121 from being wrinkled (which may result in affecting waterproof and acoustic property of the second waterproof membrane 121) due to receiving a great impact. In some embodiments, the second buffer 122 is a foam adhesive or an elastomeric acrylic adhesive or a foam matrix + elastomeric acrylic adhesive. In some embodiments, a thickness of the second buffer 122 is greater than or equal to 0.1 mm. Since the second buffer 122 has a certain thickness, the height/thickness of the second waterproof assembly 120 is increased and the waterproof assembly 120 can be adapted to (e.g., adapted to the depth of the third accommodation cavity 112) an assembly space reserved in the housing 110. Meanwhile, the height of the second waterproof assembly 120 is adapted to and greater than the height of the third accommodation sidewall 112-A, so that the second waterproof assembly 120, after being assembled into the third accommodation cavity 112, is compressed by the second acoustic assembly 130. Further, since the second buffer 122 has a certain thickness, a deformability of the second waterproof assembly 120 is increased be to adapted to a manufacturing error of different third accommodation cavities 112, making that it is easier to assemble the second waterproof assembly 120 into the third accommodation cavity 112.

In some embodiments, the second waterproof assembly 120 also includes a screen mesh. The screen mesh may be disposed on a side of the second waterproof assembly 120 away from the third sound guiding hole 112-C. When the second waterproof membrane 121 is subjected to a great water pressure, the second waterproof membrane 121 may deform. In this situation, the screen mesh may play a role of supporting or blocking behind the second waterproof membrane 121, so as to avoid an excessive deformation (which may lead to changes in an acoustic property of the second waterproof membrane 121) of the second waterproof membrane 121 and increase a waterproof capability of the second waterproof membrane 121. The fourth bonding surface 122-C may be adhered to the screen mesh, and a side of the screen mesh facing the second acoustic assembly 120 may be fixed to the second acoustic assembly 120 by bonding. In some embodiments, the screen mesh is provided on a side of the second waterproof assembly 120 close to the third sound guiding hole 112-C. When a user wears the earphone for an underwater activity and when there is a waterflow entering the acoustic device 01 from the third sound guiding hole 112-C, the waterflow may first flow through the screen mesh. In this situation, the screen mesh may disperse the waterflow through mesh holes, which makes an impact force on the second waterproof membrane 121 relatively dispersed, so that the force on the second waterproof membrane 121 is relatively small, and the second waterproof membrane 121 is not easy to deform, thereby improving the waterproof capability of the second waterproof membrane 121 (the second waterproof assembly 120).

As shown in FIG. 2C, the second acoustic assembly 130 may include a second acoustic transducer 131 and a second circuit board 132. The second acoustic assembly 130 covers on the third accommodation cavity 112.

The second acoustic transducer 131 may include a second sound transmission hole 131-A. In some embodiments, the second acoustic transducer 131 includes at least one microphone. The microphone may receive an ambient sound through the second waterproof assembly 120 via the second sound transmission hole 131-A. In some embodiments, the second acoustic transducer 131 includes at least one speaker. The speaker works to produce a target sound. The target sound may pass through the second sound transmission hole 131-A, and then may be transmitted out of the acoustic device 01 through the second waterproof assembly 120. The second waterproof assembly 120 covers the third sound transmission hole 112-C to prevent water from contacting the second acoustic transducer 131 through the second waterproof assembly 120. In some embodiments, a center axis of the second sound transmission hole 131-A and a center axis of the second center hole 122-A of the second buffer 122 are set to coincide with each other, thereby ensuring that a sound transmission path is shortest and the acoustic device 01 has a good acoustic performance. In some embodiments, the center axis of the second sound transmission hole 131-A and the center axis of the second center hole 122-A of the second buffer 122 are set to not coincide with each other (i.e., be eccentrically arranged), thereby adapting to a situation that there is insufficient space in the housing 110.

The second circuit board 132 may be mechanically connected to the second acoustic transducer 131. The mechanical connection may be bonding, SMT patching, hand soldering, nibbling connections, riveting, etc. For example, the second acoustic transducer 131 is fixed to the second circuit board 132 by means of SMT patching. The second circuit board 132 may be disposed between the second acoustic transducer 131 and the second waterproof assembly 120. As previously described, the second acoustic assembly 130 may be adhered to the second waterproof assembly 120 through the fourth bonding surface 122-C of the second buffer 122. Specifically, the second circuit board 132 may be connected to the second waterproof assembly 120 by bonding to the fourth bonding surface 122-C of the second buffer 122, thereby allowing the second acoustic assembly 130 to be connected to the second waterproof assembly 120. In some embodiments, a pressure can be applied to the second acoustic assembly 130 such that the second circuit board 132 is adhered more securely to the fourth bonding surface 122-C. For example, the pressure is applied to the second acoustic assembly 130 by downwardly pressing the second acoustic assembly by a pressure fixture. For another example, the pressure is applied to the second acoustic assembly 130 by placing a weight on it.

In some embodiments, the second circuit board 132 is at least partially disposed within the third accommodation cavity 112. In some embodiments, the second circuit board 132 is disposed outside the third accommodation cavity 112. For example, the second circuit board 132 abuts against a top surface of the third accommodation sidewall 112-A of the third accommodation cavity 112.

In some embodiments, an extension direction of a board surface of the second circuit board 132 is designed according to connection requirements. As shown in FIG. 2B, the second circuit board 132 extends from the housing sidewall 110-A to the housing bottom wall 110-B, and the second circuit board 132 is disposed on the same wall with the second accommodation cavity 111, thereby facilitating a connection with the acoustic module 20.

In some embodiments, a plurality of second positioning holes 132-A are provided on the second circuit board 132, and a plurality of second positioning projections 132-B in a one-to-one correspondence with the plurality of second positioning holes 132-A are distributed along an opening of the second accommodation cavity 112 on the housing 110. By providing the second positioning holes 132 and the second positioning projections 132-B, it is convenient to set the second sound transmission hole 131-A and the second center hole 122-A of the second buffer 122 opposite to each other, thereby ensuring that the sound transmission path is the shortest and ensuring the good acoustic performance of the acoustic device 01. For example, the second circuit board 132 is provided with four second positioning holes 132-A, and the housing 110 is provided with four second positioning projections 132-B. The present disclosure does not limit a count of the positioning projections and a count of the positioning holes. In some embodiments, there are a plurality of second positioning projections 132-B. The plurality of second positioning projections 132-B are distributed around the second acoustic transducer 131. In some embodiments, the plurality of second positioning projections 132-B are ununiformly disposed around the second waterproof assembly 120 or the second acoustic transducer 131. In some embodiments, the plurality of second positioning projections 132-B are uniformly or substantially uniformly disposed around the second waterproof assembly 120 or the second acoustic transducer 131, thereby facilitating positioning. For example, lines connecting four second positioning projections 132-B enclose a square, and the four second positioning projections 132-B are uniformly distributed around the second acoustic transducer 131.

In some embodiments, the second positioning projection 132-B may be cylindrical. In some embodiments, the second positioning projection 132-B may be a frustum that is narrow at the top and wide at the bottom, thereby avoiding an interference with the second positioning hole 132-A during installation.

In some embodiments, the second circuit board 132 is a printed circuit board (PCB). The PCB is not easy to bend and has a certain degree of hardness, thus it can well support the second acoustic transducer 131.

In some embodiments, the second circuit board 132 is a flexible printed circuit (FPC). The FPC is flexible and can be bent. By bending the FPC, it is possible to reduce a space occupancy in the housing 110. To increase a localized thickness or hardness of the FPC and to ensure a flatness of the FPC, the FPC may be strengthened locally or as a whole. For example, the second acoustic assembly 130 includes a steel plate or a polymide (PI) material as a second reinforcement plate 133 to reinforce the FPC. The PI material is an engineering plastic with excellent mechanical properties, which has a light weight, a small thickness, and a good bending property. The second reinforcement plate 133 may be disposed between the second circuit board 132 and the second waterproof assembly 120. The second reinforcement plate 133 may abut against a top surface 112-D of the third accommodation cavity sidewall 112-A, as shown in FIG. 2C. The second positioning hole 132-A may be opened on the second reinforcement plate 133. As shown in FIG. 2B, three second positioning holes 132-A may be provided on the second reinforcement plate 133, and the three second positioning holes 132-A are triangularly and approximately uniformly distributed around the second acoustic transducer 131. In some embodiments, the housing 110 is provided with four second positioning projections 132-B, and the second reinforcement plate 133 is provided with four second positioning holes 132-A. The four second positioning holes 132-A and the four second positioning projections 132-B may be distributed in a rectangular shape around the second acoustic transducer 131.

As previously described, the second buffer 122 may be elastic and can be compressed. An adhesive property and a sealing property of the second buffer 122 are related to a compression degree (a compression ratio) of the second buffer 122. Take the second buffer 122 being a foam adhesive as an example for illustration. The sealing property (the waterproofness) and the adhesive property of the foam adhesive are positively correlated to some extent with the compression ratio of the foam. That is, the higher the compression of the foam adhesive is, the higher the compression ratio is, the better the sealing property of the foam adhesive may be, and the stronger the bonding may be. Accordingly, keeping the compression ratio of the foam adhesive above a preset value may ensure a good and stable waterproof performance of the acoustic device 01. The compression ratio of the second buffer 122 may be calculated by the following formular: (original thickness-compressed thickness)/original thickness x 100%.

For example, firstly, the original thickness of the second buffer 122 is recorded. Secondly, when the second buffer 122 is pressed down, the compressed thickness of the second buffer 122 is recorded. Accordingly, the compression ratio of the second buffer 122 can be obtained. The preset value may depend on the material of the second buffer 122. For example, when the second buffer 122 is the foam adhesive, the preset value of the compression ratio is in a range of 10%-60%, for example, the compression ratio is 50%, which ensures the sealing property and the bonding property of the foam adhesive.

As previously mentioned, the second buffer 122 may also be a foam matrix + acrylic adhesive. Similarly, the higher the compression of the foam matrix + acrylic adhesive is, the higher the compression ratio is, the better the sealing property and the stronger the bonding may be. Accordingly, keeping the compression ratio of foam matrix + acrylic adhesive between 10% and 60% ensures a good and stable waterproof of the acoustic device.

Due to a relatively light mass of the second acoustic assembly 130, by placing the second acoustic assembly 130 on the second waterproof assembly 120, the compression ratio of the second buffer 122 may not reach the above-described preset value. Thus, in some embodiments, a heavy object is placed on the second acoustic assembly 130 to make the compression ratio of the second buffer 122 reach the preset value described above. For example, the heavy object is placed on the second circuit board 132. A gravity of the heavy object causes the second circuit board 132 to press down on the second buffer 122 so that the compression ratio is kept above the preset value. In some embodiments, the compression of the second buffer 122 is achieved using a thermal fuse process. Specifically, the compression of the second buffer 122 is achieved by utilizing a gravity of a plastic member of a thermally fused portion to press down on the second acoustic assembly 130.

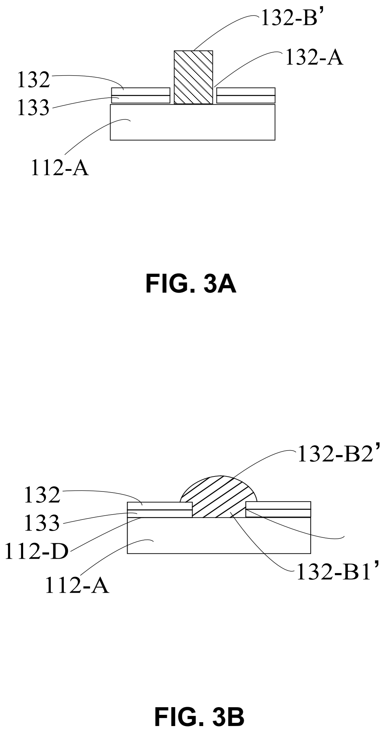

In some embodiments, the second positioning projection 132-B may be a second thermally fused column 132-B' including a thermally fused material, such as a plastic member. FIG. 3A is a schematic diagram illustrating a shape of a second thermally fused column before being thermally fused according to some embodiments of the present disclosure. FIG. 3B is a schematic diagram illustrating a shape of a second thermally fused column shown in FIG. 3A of the present disclosure after being thermally fused. The second thermally fused column 132-B' is shown by a shaded portion.

As shown in FIG. 3A, before being thermally fused, the second thermally fused column 132-B' is a column that passes through the second positioning hole 132-A, with a gap between it and the second circuit board 132. The second thermally fused column 132-B' may be a solid thermally fused column, a ribbed thermally fused column, a hollow thermally fused column, etc., which is not limited herein. The second thermally fused column 132-B' may be fused and remold by heating. A method for heating the thermally fused column may be a hot air thermal fuse process, a pulsed thermal fuse process, an ultrasonic thermal fuse process, etc., which is not limited herein.

As shown in FIG. 3B, a molded second thermally fused column 132-B' may include a second column body 132-B1' and an expanded second column head 132-B2'. The expanded second column head 132-B2' is formed by the deformation of a top portion of the second thermally fused column 132-B' after being thermal fused. The second column body 132-B1' is inserted through a corresponding second positioning hole 132-A, and the second column head 132-B2' may abut against an upper surface of the second circuit board 132, thereby fixing the second acoustic assembly 130 to the top surface 112-D of the third accommodation sidewall 112-A and pressing the second waterproof assembly 120 (the second buffer 122) tightly.

In some embodiments, all the plurality of second positioning projections 132-B are the second thermally fused columns 132-B', and thus are thermally fused for pressing the second waterproof assembly 120 tightly. In some embodiments, parts of the plurality of second positioning projections 132-B are the second thermally fused columns 132-B'; and the other parts are merely used for positioning. In some embodiments, the plurality of second thermally fused columns 132-B' surround in all directions to ensure that the second waterproof assembly 120 is under pressure at all angles. Further, the plurality of second thermally fused columns 132-B' are ununiformly distributed around the second acoustic transducer 131 to apply pressure to particular position(s) of the second waterproof assembly 120. In some embodiments, the second thermally fused columns 132-B' are uniformly distributed around the second acoustic transducer 131 such that the second acoustic assembly 120 is subjected to a uniform pressure, thereby enabling the second buffer 122 to compress uniformly.

By adopting the thermal-fuse compression process to make the second positioning projection 132-B to form a rivet-like structure to compress the second buffer 122 and to fix the second acoustic assembly 130 to the housing, the operation is simple and efficient, the thermally fused material also seals a gap between the second positioning projection 132-B and the second positioning hole 132-A, and there is no need to seal the gap between the second positioning projection 132-B and the second positioning hole 132-A again, which is simple in operation, efficient, and reduces cost.

In some embodiments, a surface of the second acoustic assembly 130 may be further sealed by using a sealant. By using the sealant, on the one hand, a firmness of the second acoustic assembly 130 within the housing 110 may be strengthened, preventing the second thermally fused column 132-B' from falling off during a long-term usage, which may cause a state of the second waterproof membrane 121 to change and thus affect the acoustic and waterproof performance; on the other hand, the gap between the second waterproof assembly 120 and the third accommodation sidewall 112-A may be further filled to prevent water from entering from layers of the second waterproof assembly 120 close to the sidewall, which may lead to a waterproof failure. In some embodiments, the sealant is an ultraviolet rays adhesive (UV adhesive for brevity), silicone, a thermal fuse adhesive, etc.

When the acoustic transducer is mounted within the acoustic device 01, a sensitivity difference usually exits before and after the acoustic transducer is assembled to the housing due to a mounting error, a difference among different acoustic transducers, etc. Specifically, in some embodiments of the present disclosure, during installation of the second acoustic transducer 131 according to the above-described manner in which the second waterproof assembly 120 and the second acoustic assembly 130 are sequentially installed to the housing 110, the sensitivity of the second acoustic transducer 131 may change. In some embodiments, the second acoustic transducer 131 has a first initial sensitivity when detached from the third accommodation cavity 112 (not assembled to the third accommodation cavity 112), and the second acoustic transducer 131 has a first assembly sensitivity when mounted to the housing 110. Typically, the first initial sensitivity and the first assembly sensitivity are different and a difference between the two sensitivities is less than 1.9 dB. Factors affecting the sensitivity change of the second acoustic transducer 131 may include a wrinkling degree of the second waterproof membrane 121, a compression degree of the second waterproof membrane 121, a cavity burr of the third accommodation cavity 112, etc. After the second acoustic transducer 131 is mounted in the housing 110 using the manner described above, the second acoustic transducer 131 is no longer easily removed and the sensitivity is nearly fixed due to the assembly factors. In this situation, if the first acoustic transducer 231 is mounted into the housing using the same manner, a sensitivity difference (S_{gap}) between the first acoustic transducer 231 and the second acoustic transducer 131 is uncontrollable, which results in an uncontrollable sensitivity consistency among different acoustic devices 01.

In particular, when the acoustic device 01 includes two or more acoustic transducers, there is usually a sensitivity difference (i.e., S_{gap}) among the acoustic transducers due to the aforementioned installation error, the differences among different acoustic transducers, etc., which results in a post-assembly sensitivity (also referred to as an assembly sensitivity) consistency among multiple acoustic devices 01 may be poor, thereby affecting a yield rate of the acoustic devices 01. The assembly sensitivity consistency is a S_{gap} difference among different acoustic devices 01, and a poor assembly sensitivity consistency represents a greater S_{gap} difference among the acoustic devices 01. In this situation, the sensitivity consistency among a plurality of acoustic devices 01 may be modulated by a preset algorithm. For example, an assembly sensitivity difference among a plurality of acoustic transducers in acoustic device A is S_{gapA}; an assembly sensitivity difference among a plurality of acoustic transducers in acoustic device B is S_{gapB}, and an assembly sensitivity difference among a plurality of acoustic transducers in acoustic device C is S_{gapC}. For the acoustic device A, the acoustic device B, and the acoustic device C, it is expected to adjust the S_{gap} among the plurality of acoustic transducers by using a same circuit design or using an adjusting algorithm. Accordingly, a difference between any two S_{gap} among S_{gapA}, S_{gapB}, and S_{gapC} may be maintained within a preset value range. However, for the adjusting algorithmic, there is usually a certain threshold range, which makes it difficult to improve the sensitivity consistency among the plurality of acoustic devices at the same time and ensure yield rate.

The present disclosure therefore provides an acoustic module 20. The acoustic module 20 is an individual module separate from the housing assembly 10. The acoustic module 20 has been processed to be liquid (water) resistant, so the assembly sensitivity of the acoustic module 20 is basically fixed.

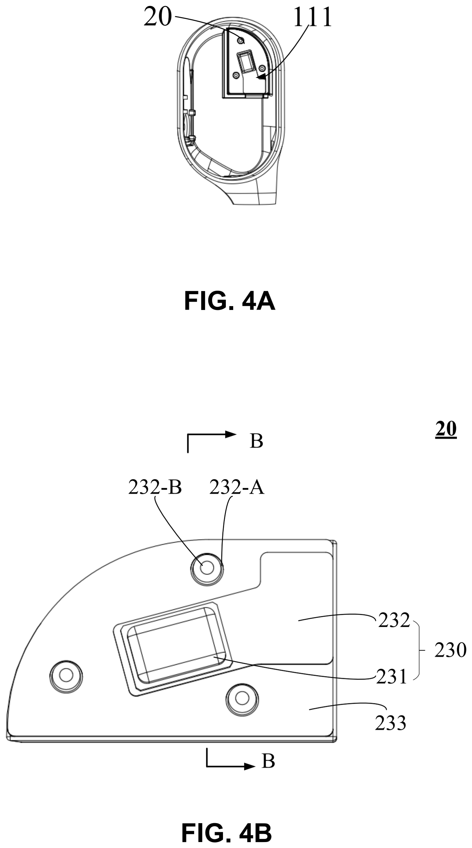

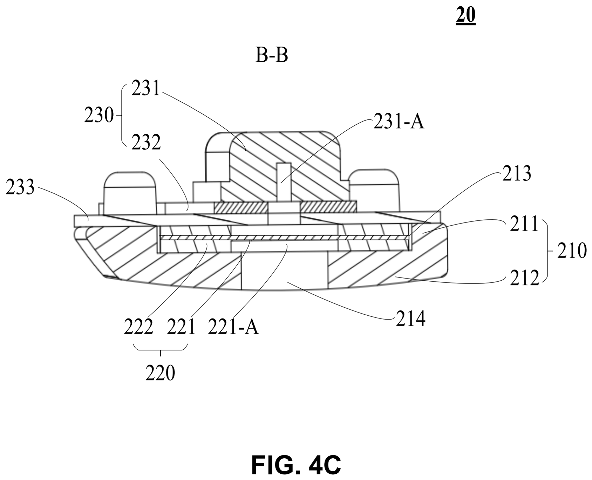

The following describes specific assemblies of the acoustic module 20. FIG. 4A is a schematic diagram illustrating the acoustic module 20 mounted in a second accommodation cavity according to some embodiments of the present disclosure. FIG. 4B is a schematic diagram illustrating the acoustic module 20 according to some embodiments of the present disclosure. FIG. 4C is a B-B sectional view of an acoustic module shown in FIG. 4B of the present disclosure. As shown in FIG. 4A-FIG. 4C, the acoustic module 20 may include a base 210, a first waterproof assembly 220, and a first acoustic assembly 230.

In some embodiments, an overall shape of the base 210 is adapted to an accommodation space of the second accommodation cavity 111, such that the base 210 can be installed within the second accommodation cavity 111. As shown in FIG. 4C, the base 210 may include a base sidewall 211, a base bottom wall 212, and a first sound guiding hole 214. The base sidewall 211 and the base bottom wall 212 form a first accommodation cavity 213 to accommodate other assemblies (e.g., the first waterproof assembly 220, the first acoustic assembly 230, etc.). The base 210 may be provided with the first sound guiding hole 214. The first sound guiding hole 214 may pass through the base bottom wall 212 and communicate with the first accommodation cavity 213. For example, the base bottom wall 212 is provided with the first sound guiding hole 214. After the base 210 is installed in the second accommodation cavity 111, the first sound guiding hole 214 may communicate with the second sound guiding hole 111-C in the second accommodation cavity 111 to ensure that sound is transmitted in or out through the two holes. In some embodiments, an opening of the first sound guiding hole 214 and an opening of the second sound guiding hole 111-C in the second accommodation bottom wall 111-B are not coaxial. In some embodiments, the opening of the first sound guiding hole 214 and the opening of the second sound guiding hole 111-C in the second accommodation bottom wall 111-B are coaxial to each other, making that the sound transmission path is shortest and the acoustic device 01 has a good acoustic performance.

As shown in FIG. 4C, the first waterproof assembly 220 may be mounted within the first accommodation cavity 213, sealedly connected to the first accommodation cavity 213, and may cover the first sound guiding hole 214 to prevent liquid (water) from entering the first accommodation cavity 213 through the first sound guiding hole 214. The first acoustic assembly 230 may be disposed on a side of the first waterproof assembly 220 away from the base bottom wall 212.

In some embodiments, the first waterproof assembly 220 includes a first waterproof membrane 221 and a first buffer 222. The first waterproof membrane 221 may have all of the properties of the second waterproof membrane 121 described above. For example, the first waterproof membrane 221 allows air to pass through and blocks water from passing through the first waterproof membrane 221. The first buffer 222 may be provided with a first center hole 222-A. The first buffer 222 may abut against the first waterproof membrane 221, specifically, an edge region of the first buffer 222 may abut against an edge region of the first waterproof membrane 221. In some embodiments, the first center hole 222-A and the first sound guiding hole 214 are not coaxial. In some embodiments, the first center hole 222-A and the first sound guiding hole 214 are coaxial, making the first waterproof membrane 221 less likely to be broken (which may result in a reduced waterproof effect or even failure of the first waterproof assembly 220) due to ununiform water pressure. In some embodiments, the first center hole 222-A and the first sounding hole 214 are adaptive in shape. Similar to the aforementioned second center hole 122-A, the shape of the first center hole 222-A may be any shape such as round, oval, square, rectangular, etc., which is not limited in the present disclosure. In some embodiments, a hole diameter of the first center hole 222-A is greater than a hole diameter of the first sound guiding hole 214 to allow a greater area of the first waterproof membrane 221 to bear the water pressure, so that the first waterproof membrane 221 is less likely to be broken. The hole diameter may be a diameter of the hole.

In some embodiments, the first waterproof assembly 220 includes a bonding surface, so that the bonding surface can be adhered to the bottom wall of the first accommodation cavity 213 after the first waterproof assembly 220 is placed in the first accommodation cavity 213, thereby realizing a sealed connection between the first waterproof assembly 220 and the first accommodation cavity 213 and a fixation of the first waterproof assembly 220. For example, the first waterproof assembly 220 includes a first bonding surface 222-B and a second bonding surface 222-C. The first bonding surface 222-B may bond the first waterproof assembly 220 within the first accommodation cavity 213 after being subjected to an external pressure. The external pressure may be a gravity of the first acoustic assembly 230, or may be a pressure applied by a pressure fixture. When the first waterproof assembly 220 and the first acoustic assembly 230 contact each other, the second bonding surface 222-C may enable the first waterproof assembly 220 and the first acoustic assembly 230 to be sealedly bonded.

Specifically, the first waterproof assembly 220 may include two first buffers 222 disposed on both sides of the first waterproof membrane 221. Two surfaces of the first buffers 222 facing the first accommodation cavity 213 and the first acoustic assembly 230 may be adhesive. By providing the bonding surface, the first waterproof assembly 220 is fixed in the first accommodation cavity 213 through adhesive bonding, which realizes a waterproof effect and ensures the simplicity and convenience of the operation process. The first waterproof assembly 220 may have all the properties of the second waterproof assembly 120 described above, which are not described herein.

The first acoustic assembly 230 may include a first acoustic transducer 231 and a first circuit board 232. The first acoustic transducer 231 may be disposed on a side of the first waterproof assembly 220 away from the base bottom wall 212. The first circuit board 232 may be disposed between the first acoustic transducer 231 and the first waterproof assembly 220.

The first acoustic transducer 231 may include a first sound transmission hole 231-A. The first acoustic transducer 231 may have the same properties as the second acoustic transducer 131 described above, which are not described herein.

The first circuit board 232 may be mechanically connected to the first acoustic transducer 231. For example, the first acoustic transducer 231 may be fixed to the first circuit board 232 by soldering. As previously described, the first acoustic assembly 230 may be bonded to the first waterproof assembly 220 via the second bonding surface 222-C. In some embodiments, a pressure is applied to the first acoustic assembly 230 such that the first circuit board 232 is adhered more strongly to the second bonding surface 222-C. For example, a pressure is applied to the first acoustic assembly 230 via a pressure fixture. For another example, the pressure is applied to the first acoustic assembly 230 by placing a heavy object on the first acoustic assembly 230.

In some embodiments, the first circuit board 232 is at least partially disposed within the first accommodation cavity 213. In some embodiments, the first circuit board 232 is disposed outside the first accommodation cavity 213. For example, the first circuit board 232 is disposed outside the first accommodation cavity 213 and abuts against a top surface of the base sidewall 211.

In some embodiments, a plurality of first positioning holes 232-A are provided on the first circuit board 232, and a plurality of first positioning projections 232-B in a one-to-one correspondence with the plurality of first positioning holes 232-A are provided on the top surface of the base sidewall 211. By providing the first positioning holes 232-A and the first positioning projections 232-B, it is convenient to set the first sound transmission hole 231-A and the first center hole 222-A of the first buffer member 222 opposite to each other, thereby ensuring that a sound transmission path is the shortest and ensuring that the acoustic device 01 has a good acoustic performance. In some embodiments, there are a plurality of first positioning projections 232-B. The plurality of first positioning projections 232-B are distributed in different directions around the first waterproof assembly 220 or the second acoustic transducer 231. In some embodiments, the plurality of first positioning projections 232-B are ununiformly disposed around the first waterproof assembly 220 or the second acoustic transducer 231. In some embodiments, the plurality of first positioning projections 232-B are uniformly or substantially uniformly spaced around the first waterproof assembly 220 or the second acoustic transducer 231, thereby facilitating positioning. For example, lines connecting three first positioning projections 232-B in FIG. 4B surrounds a triangle, and the three first positioning projections 232-B are uniformly distributed around the first acoustic transducer 231. There are three first positioning projections 232-B and three first positioning holes 232-A, as shown in FIG. 4 B. The present disclosure does not limit a count of the positioning projections and a count of the positioning holes.

In some embodiments, the first positioning projection 232-B may be cylindrical, as shown in FIG. 4B. In some embodiments, the first positioning projection 232-B may be a frustum that is narrow at the top and wide at the bottom, so as to avoid interfering with the first positioning hole 232-A during installation. In some embodiments, the first positioning projection 232-B includes a first column body and an expanded first column head. The first column body passes through a corresponding first positioning hole 232-A.

In some embodiments, the first circuit board 232 is a PCB. The PCB is not easy to bend and has a certain hardness, thus it can well support the first acoustic transducer 231.

In some embodiments, the first circuit board 232 is an FPC. As described above, to increase a local thickness or hardness of the FPC, and to ensure a flatness of the FPC, the FPC may be strengthened locally or as a whole. The first acoustic assembly 230 may include a first reinforcement plate 233, and the first reinforcement plate 233 may have the same or similar properties as the aforementioned second reinforcement plate 133, which are not repeated herein. The first reinforcement plate 233 for reinforcing the strength of the first circuit board 232 may be disposed between the first circuit board 232 and the first waterproof assembly 220. As shown in FIG. 4C, the first reinforcement plate 233 may abut against the top surface of the base sidewall 211.

As a result, the plurality of first positioning holes 232-A may be provided on the first reinforcement plate 233. In some embodiments, the first positioning holes 232-A may be provided on the first reinforcement plate 233 and the first circuit board 232. That is, the first positioning holes 232-A on the first reinforcement plate 233 are in a one-to-one correspondence with the first positioning holes 232-A on the first circuit board 232, and the first positioning protrusion 232-B passes through the first positioning hole 232-A on both the first reinforcement plate 233 and the first circuit board 232 at the same time. When the first positioning projection 232-B is the first thermally fused column described above, the first column head obtained by thermal fuse process may abut against the upper surface of the first circuit board 232.

In some embodiments, the first circuit board 232 covers only a portion of the first reinforcement plate 233, as shown in FIG. 4B. Accordingly, the first positioning hole 232-A may be opened only on the first reinforcement plate 233. As shown in FIG. 4B, the first reinforcement plate 233 is provided with three first positioning holes 232-A, and the three first positioning holes 232-A are triangularly and approximately uniformly distributed around the first acoustic transducer 231. By not opening the first positioning holes 232-A on the first circuit board 232, a circuit routing of the first circuit board 232 may not be affected.

In some embodiments, each of the first positioning projections 232-B has the same or similar structure as the aforementioned second positioning projection 123-B. For example, each of the first positioning projections 232-B includes a first column body and an expanded first column head. For example, the first column body is a screw, and the first column head is a screw cap; furthermore, the first positioning projection 232-B is a thermally fused column, which is referred to as the first thermally fused column. The first column head of the above-described first positioning projection 232-B may be formed by deformation of a top portion of the first thermally fused column after being thermally fused, so that after the first positioning projection 232-B is thermally fused, the elastic first buffer 222 is uniformly pressed downward to ensure the sealing and bonding of the first waterproof assembly 220. The first column head may abut against the upper surface of the first reinforcement plate 233. A specific thermally fused form can be referred to the second thermally fused column 132-B' described above (referring to FIG. 3B). The specific process of thermally fusing the first thermally fused column and the specific manner of thermally fuse process can be referred to the second thermally fused column 132-B', which are not repeated here. The first column head of the first positioning projection 232-B may be formed by deformation of the top portion of the first thermally fused column after being thermally fused. The first column head may abut against an upper surface of the first reinforcement plate 233. The specific thermally fused form can be referred to the second thermally fused column 132-B' above (referring to FIG. 3B).

The first circuit board 232 and the second circuit board 132 may be electrically connected to each other, thereby realizing a connection between the first acoustic transducer 231 and the second acoustic transducer 132, so that the two can cooperate with each other. For example, the electrical connection between the first circuit board 232 and the second circuit board 132 is realized directly by soldering. For another example, the first circuit board 232 and the second circuit board 132 are respectively soldered to another circuit board (a connecting circuit board), so that the electrical connection is realized through the circuit board. For another example, the first circuit board 232 and the second circuit board 132 are electrically connected to each other via a board-to-board connector (BTB connector). As previously mentioned, in some embodiments, the second circuit board 132 extends to the housing bottom wall 110-B and is on the same wall with the second accommodation cavity 111, thereby shortening a distance with the first circuit board 232. Accordingly, by using the connecting circuit board to connect the first circuit board 232 and the second circuit board 132, an internal space occupied in the housing 110 may be reduced compared with using the BTB, and a cost may be saved.

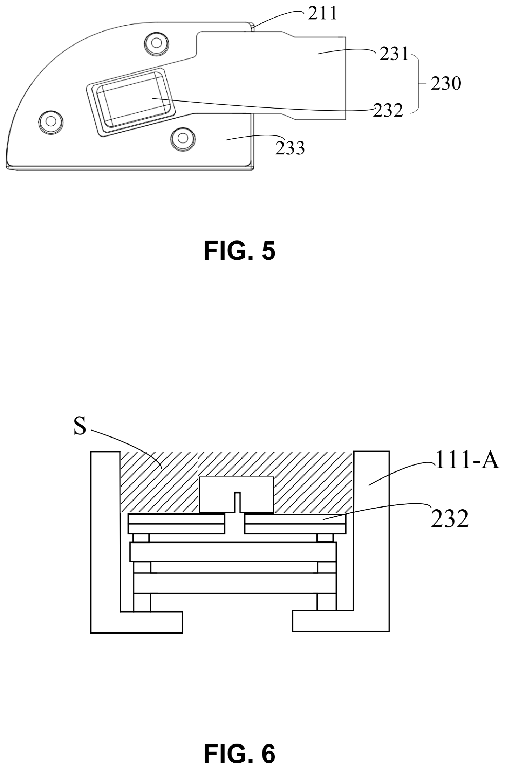

In some embodiments, the first circuit board 232 is flush with an edge of the base 210. For example, as shown in FIG. 4A, an edge of the first circuit board 232 is flush with an edge of the base sidewall 211. In some embodiments, a covering range of the first circuit board 232 exceeds the base 210. FIG. 5 is a schematic diagram illustrating a structure of another acoustic module 20 according to some embodiments of the present disclosure. As shown in FIG. 5, a right side of the first circuit board 232 exceeds an edge of the base sidewall 211. An exceeding portion of the first circuit board 232 may cross over the base sidewall 211 and then bend until contacting the housing bottom wall 110-B, such that it can be directly connected to the second circuit board 132 or connected to the second circuit board 132 via a connecting circuit board. By designing the first circuit board 232 to extend beyond the base 210, it is possible to make a connection point (e.g., a soldering point_ between the first circuit board 232 and a circuit board to be connected located on the housing bottom wall 110-B. In this way, it is more convenient to realize the connection compared with locating the connection point at an edge of the base 210.

In some embodiments, the second accommodation sidewall 111-A is higher than an upper surface of the first circuit board 232, thereby forming an accommodation space S to accommodate a second sealing member. FIG. 6 is a diagram illustrating a position relationship between the second accommodation sidewall 111-A and the first circuit board 232 according to some embodiments of the present disclosure. The accommodation space S is shaded in FIG. 6. In some embodiments, the second sealing member is a sealant. In some embodiments, the sealant is a UV adhesive.

As previously described, the first circuit board 232 may be an FPC and a right side of the first circuit board 232 may extend beyond an edge of the base sidewall 211. Therefore, when the second accommodation sidewall 111-A is higher than an upper surface of the first circuit board 232, the first circuit board 232 needs to be bent inside the second accommodation cavity 111 and then extended out of the second accommodation cavity 111, over the second accommodation sidewall 111-A, and then bent to the second accommodation bottom wall 111-B to connect with a portion of the second circuit board 132 extending to the second accommodation bottom wall 111-B, reducing a space occupation in the housing 110.

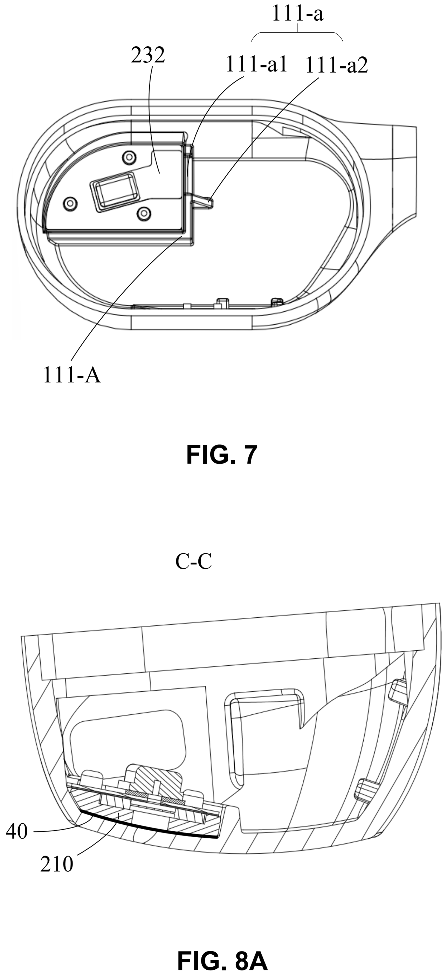

FIG. 7 is a schematic diagram illustrating a second accommodation sidewall 111-A according to some embodiments of the present disclosure. A portion of the first circuit board 232 that extends beyond an edge of the base sidewall 211 is not shown in FIG. 7. To reduce a bending degree of the first circuit board 232 as it crosses over the second accommodation cavity 111, and to prevent the first circuit board from being damaged due to excessive bending at the second accommodation cavity sidewall 111-A, the second accommodation sidewall 111-A may be provided with a target section 111-a as shown in FIG. 7. The first circuit board 232 may cross the second accommodation sidewall 111-A from the target section 111-a of the second accommodation sidewall 111-A.

Compared with other portions of the second accommodation sidewall 111-A, the target section 111-a may have a more gentle design, thereby reducing the bending degree of the first circuit board 232 at the second accommodation sidewall 111-A, and further improving a service life of the first circuit board 232.

For example, corner angles of other portions of the second accommodation sidewall 111-A have be right angles, however, the gentle design of the target section 111-A results in that the corner angle thereof is rounded. For another example, corner angles of the other portions of the second accommodation sidewall 111-A are relatively small rounded angle, and the gentle design of the target section 111-a results in that the corner angle thereof is a relatively large rounded angle. For another example, height differences between the other portions of the second accommodation sidewall 111-A and an inner wall of the housing 110 are relatively high, the gentle design of the target section 111-a results in that a height difference thereof is relatively small, with a slope support with the inner wall of the housing 110. As shown in FIG. 7, the target section 111-a may include a guiding opening 111-a1 opened in the second accommodation sidewall 111-A and an inclined guiding surface 111-a2. The upper surface of the first circuit board 232 may be flush with an upper surface of the guiding opening 111-a1, such that the first circuit board 232 does not have to be bent to cross over the second accommodation sidewall 111-A. The guide opening 111-a1 may be connected to the inner wall of the housing 110 by the inclined guiding surface 111-a2. Due to the certain height difference between the guiding opening 111-a1 and the inner wall of the housing 110, the guiding surface 111-a2 may be disposed to support the first circuit board 232 to prevent the first circuit board 232 from overhanging and to reduce a risk for the first circuit board 232 from being damaged.

In some embodiments, the bending degree of the first circuit board 232 at the sidewall section of the second accommodation sidewall 111-A is measured by a bending angle of the first circuit board 232. The smaller the bending angle is, the lower the bending degree may be. For example, the bending degree is lower when the bending angle is an acute angle; the bending degree is higher when the bending angle is a right angle. If the guiding surface 111-a2 is not provided, the first circuit board 232 needs to be bent at a right angle along the second accommodation sidewall 111-A. As shown in FIG. 7, since the inclined guide surface 111-a2 is provided, a sharp bending angle is avoided when the first circuit board 232 is bent downward. The support of the guiding surface 111-a2 causes the bending angle of the first circuit board 232 to be an acute small angle. In some embodiments, compared with the right-angle design of other sections, a rounded angle design is provided for the target section 111, so that the first circuit board 232 bends along the rounded angle when passing through the second accommodation sidewall 111-A, and no direct bending occurs, thereby extending the service life of the first circuit board 232.

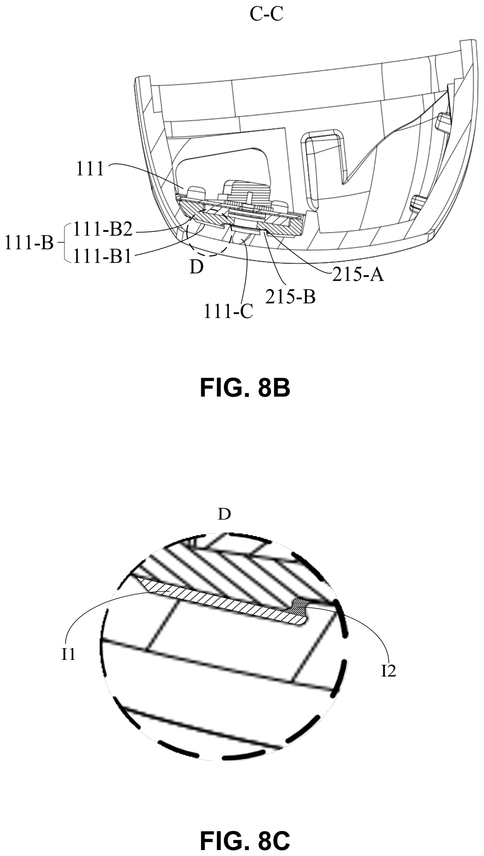

FIG. 8A is a C-C sectional view of the acoustic device 01 shown in FIG. 1 of the present disclosure. FIG. 8B is another C-C sectional view of the acoustic device 01 shown in FIG. 1 of the present disclosure. FIG. 8C is an enlarged view of a part "D" shown in FIG. 8B.

As previously described, the base 210 and the second accommodation cavity 111 are sealedly connected. In some embodiments, the base 210 and the second accommodation cavity 111 are sealedly connected to each other by a first sealing member 40 (shown in the black part). The first sealing member 40 may be a preformed sealing gasket. As shown in FIG. 8A, the first sealing member 40 may be pre-bonded to the second accommodation bottom wall 111-B, and then the acoustic module 20 may be fixed with the second accommodation cavity 111 by placing the acoustic module 20 on the first sealing member 40. In some embodiments, the sealing gasket is a double-sided adhesive, a foam adhesive, or a foam substrate + double-sided adhesive.

As previously described, the second accommodation sidewall 111-A and the second accommodation bottom wall 111-B of the second accommodation cavity 111 may be formed inside the housing 110. In some embodiments, the second accommodation bottom wall 111-B may include a first step. As shown in FIG. 8B, the first step may divide the second accommodation bottom wall into a first bottom wall 111-B1 and a second bottom wall 111-B2. The second sound guiding hole 111-C penetrates the first bottom wall 111-B1 and communicates with the second accommodation cavity 111. The base 210 may abut against the second bottom wall 111-B2. The base 210 may form a first gap I1 (shown in shaded part in FIG. 8C) with the first bottom wall 111-B1. The first sealing member 40 may be in the first gap I1 and seal the first gap I1.

The first sealing member 40 may be the sealing gasket as described above or may be a cured fluid sealing material. To reduce an assembling difficulty between the acoustic module 20 and the second accommodation cavity 111, a size of the acoustic module 20 is slightly smaller than a size of the second accommodation cavity 111. Thus, there may be a gap between the acoustic module 20 and the second accommodation sidewall 111-A. The fluid sealing material may enter the first gap I1 along the gap. The fluid sealing material may be cured in the first gap I1, thereby fixing the acoustic module 20 within the second accommodation cavity 111.

As the fluid sealing material may enter the second sound guiding hole 111-C during flow, and result in a partial or total filling of the second sound guiding hole 111-C, which in turn affects a sound intake. Further, it is more difficult to clean the fluid sealing material flowing into the hole when the second sound guiding hole 111-C is inclined. In some embodiments, the inflow of fluid sealing material into the second sound guiding hole 111-C is prevented by providing a limiting portion on the base 210 and the second accommodation bottom wall 111-B. Specifically, the base bottom wall 212 is provided with a first limiting portion 215-A along a circumference of the first sound guiding hole 214. The first base wall 111-B1 is provided with a circle of second limiting portion 215-B along a circumference of the second sound guiding hole 111-C. As shown in FIG. 8B, the base bottom wall 212 is provided with a circle of first limiting portion 215-A along a circumference of a hole opening of the first sound guiding hole 214. The first base wall 111-B1 is provided with a circle of second limiting portion 215-B along a circumference of a hole opening of the second sound guiding hole 111-C. Shapes and sizes of the first limiting portion 215-A and the second limiting portion 215-B mate with each other so that when assembled within the housing 110 of the acoustic device, the acoustic module 20 is coupled with the second limiting portion 215-B. The base bottom wall 212 is provided with the first limiting portion 215-A on a side facing the second accommodation cavity 111. The first limiting portion 215-A and the second limiting portion 215-B mate with and abut against each other to prevent the fluid sealing material from flowing into the second sound guiding hole 111-C. By disposing a circle of first limiting portion 215-A and a circle of second limiting portion 215-B, various ways for the fluid sealing material to flow into the second sound guiding hole 111-C may be blocked.

In some embodiments, the first limiting portion 215-A includes a groove disposed on the base bottom wall 212 along the circumference of the first sound guiding hole 214, and the second limiting portion 251-B includes a second step disposed on the first bottom wall 111-B1 along the circumference of the second sound guiding hole 111-C, as shown in FIG. 8B. The flow of the fluid sealing material into the second sound guiding hole 111-C is blocked by the second step or a similar protruding structure. By providing a corresponding groove, a height of the second step may be made higher so as to better block the flow of the fluid sealing material into the second sound guiding hole 111-C. By providing the groove and the second step, the fluid sealing material is prevented from flowing into the second sound guiding hole 111-C, and the acoustic module 20 can be positioned when placed into the second accommodation cavity 111.

In some embodiments, considering the manufacturing precision error and reducing the assembly difficulty of the acoustic module 20 with the second accommodation cavity 111, an opening of the groove is slightly greater than the second step. Accordingly, the first limiting portion 215-A and the second limiting portion 215-B may form a second gap I2 (shown in the shaded portion in FIG. 8C). The second gap I2 may also be used to accommodate the fluid sealing material. Thus after the fluid sealing material flows into the first gap I1, if there is any excess, it can enter the second gap I2, which not only ensures that the fluid sealing material does not flow into the second sound guiding hole 111-C, but also extends an accommodation path of the fluid sealing material, allowing more fluid sealing material to be placed between the acoustic module 20 and the second accommodation cavity 111, and improving a connection robustness of the acoustic module 20 and the second accommodation cavity 111.

When the first sealing member 40 is the preformed sealing gasket above, especially when the first sealing member 40 is the double-sided adhesive, after water enters the second sound guiding hole 111-C of the acoustic device 01, an adhesive force of the sealing gasket may be reduced. Therefore, a sealing member with stronger adhesive force may be used to fix the acoustic module 20, thereby ensuring a normal use of the acoustic device 01. For example, the first sealing member 40 may be silicone, a thermal fuse adhesive, etc. Silicone and the thermal fuse adhesive both have advantages of strong adhesion, low public hazards, and fast curing.

By disposing a separate acoustic module 20, a sensitivity difference of the acoustic device 01 can be flexibly adjusted to improve a sensitivity consistency among different acoustic devices 01. That is, it is possible to ensure the sensitivity difference S_{gap} among different acoustic devices 01 within a preset range, thereby ensuring a yield rate of the acoustic devices 01.

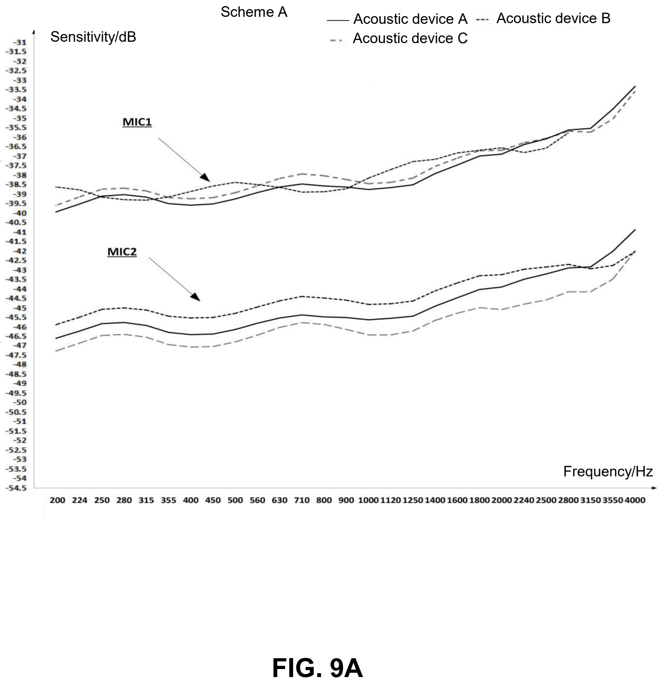

FIG. 9A is a line chart illustrating an acoustic transducer sensitivity under scheme A according to some embodiments of the present disclosure.

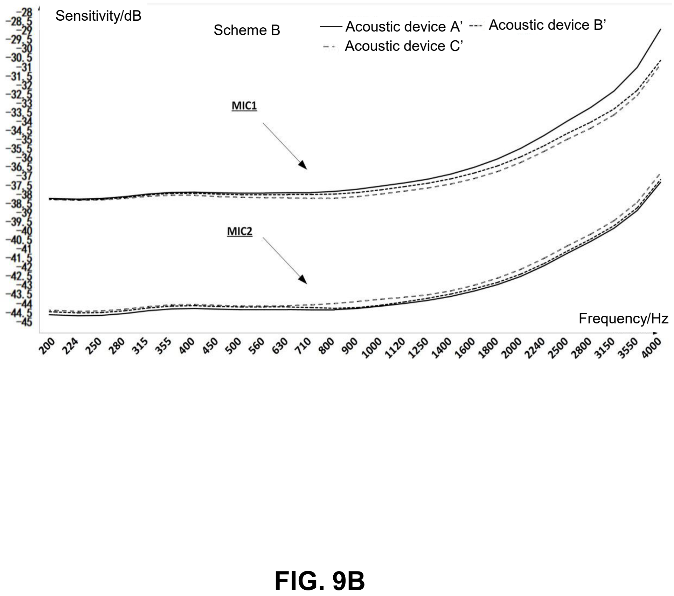

FIG. 9B is a line chart illustrating an acoustic transducer sensitivity under scheme B according to some embodiments of the present disclosure. The acoustic transducer being a microphone is taken as an example for illustration.

Under scheme A, the acoustic device 01 is obtained by a mounting manner of the second acoustic transducer 131 as described above. Three (acoustic devices A, B, and C) of numerous acoustic devices are shown in FIG. 9A. The acoustic transducer including two microphones (MIC1 and MIC2) is taken as an example for illustration. Sensitivity values of the two microphones of each of the acoustic devices are in a preset frequency band. The preset frequency band is 200Hz-4kHz, as shown in FIG. 9A. A microphone sensitivity of the same acoustic device 01 is shown using a same dash line. The three folded lines at top in FIG. 9A show a sensitivity change of MIC1; the three folded lines at bottom show a sensitivity change of MIC2. A sensitivity difference between two microphones is denoted as S_{gap}. An average sensitivity difference of the two microphones of the acoustic device A is denoted as S_{gapA}. An average sensitivity difference of the two microphones of the acoustic device B is denoted S_{gapB}. An average sensitivity difference of the two microphones of the acoustic device C is S_{gapC}. A difference S_{gapA-B} between S_{gapA} and S_{gapB} is about 1.07 dB; a difference S_{gapA-C} between S_{gapA} and S_{gapC} is about 1.9 dB; and a difference S_{gapB-C} between S_{gapB} and S_{gapC} is about 0.83 dB. That is, if the sensitivity consistency among the acoustic devices needs to be adjusted, an adjustment threshold is at least 1.9 dB.

Under scheme B, the acoustic device 01 is obtained by a manner of selecting an acoustic module 20 that satisfies a preset condition as described above. Three (acoustic devices A', B', and C') of numerous acoustic devices are shown in FIG. 9B. The acoustic transducer including two microphones (MIC1 and MIC2) is also taken as an example for illustration. Sensitivity values of the two microphones (a front microphone and a rear microphone) of each of the acoustic devices are in a preset frequency band. The preset frequency band is 200Hz-4kHz, as shown in FIG. 9B. A microphone sensitivity of the same acoustic device 01 is shown using the same folded line. The three folded lines at top in FIG. 9B shown the sensitivity change of MIC1; the three folded lines at bottom show the sensitivity change of MIC2. A sensitivity difference between the two microphones is noted as S_{gap}'. An average sensitivity difference of the two microphones of the acoustic device A' is S_{gapA'}. An average sensitivity difference of the two microphones of the acoustic device B' is S_{gapB'}. An average sensitivity difference of the two microphones of the acoustic device C' is S_{gapC'}. A difference S_{gapA'-B'} between S_{gapA'} and S_{gapB'} is about 0.47 dB; a difference S_{gapA'-C'} between S_{gapA'} and S_{gapC'} is about 0.85 dB; and a difference S_{gapB'-C'} between S_{gapB'} and S_{gapC'} is about 0.38 dB. That is, if a sensitivity consistency among the acoustic devices needs to be adjusted, an adjustment threshold only needs to reach 0.85 dB.

From the above data, it can be seen that the maximum difference of S_{gap'} under scheme B is much smaller than the maximum difference of S_{gap} under scheme A. Through the detection and statistics of the microphone sensitivities of nearly one hundred acoustic devices under scheme A and nearly one hundred acoustic devices under scheme B, it is obtained that the average value of S_{gap} of acoustic devices under scheme A is about 0.83dB-2.1dB. The average value of S_{gap} of the acoustic devices under scheme B is about 0.3dB-0.84dB. Therefore, it is considered that the sensitivity consistency of the acoustic device 01 under scheme B is higher, and a call performance of the acoustic device 01 is more stable.

The above describes specific embodiments of the present disclosure. Other embodiments are within the scope of the appended claims. In some embodiments, the actions or operations documented in the claims are performed in an order different from that of the embodiments and still achieve desirable results. Additionally, the processes depicted in the accompanying drawings do not necessarily need to be shown in a particular order or consecutive order in order to achieve the desired results. In some implementations, multitasking and parallel processing are also possible or advantageous.

In summary, after reading the present detailed disclosure, those skilled in the art may appreciate that the foregoing detailed disclosure are presented by way of example only and are not limiting. While not expressly stated herein, those skilled in the art may understand that the present disclosure needs to encompass a variety of reasonable changes, improvements, and modifications to the embodiments. These changes, improvements, and modifications are intended to be presented by the present disclosure and are within the spirit and scope of the exemplary embodiments of the present disclosure.

In addition, certain terminology in the present disclosure are used to describe embodiments of the present disclosure. For example, "an embodiment," "one embodiment," and/or "some embodiments" means that a particular feature, structure, or characteristic described in conjunction with the embodiment is included in at least one embodiment of the present disclosure. Accordingly, it may be emphasized and should be understood that the terms "embodiment" or "an embodiment" or "a count of embodiments" are not used in the present disclosure do not necessarily all refer to the same embodiment. In addition, particular features, structures, or characteristics may be suitably combined in one or more embodiments of the present disclosure.

It should be understood that in the foregoing description of embodiments of the present disclosure, various features are combined in a single embodiment, accompanying drawing, or description thereof, to aid in the understanding of a feature, and for the purpose of simplifying the present disclosure. However, this is not to say that a combination of these features is necessary, and it is entirely possible for those skilled in the art to extract some of these features as separate embodiments to be understood when reading the present disclosure. That is to say, the embodiments in the present disclosure may also be understood as a consolidation of a plurality of sub-embodiments. And this also holds true when each of the sub-embodiments lies in fewer than all of the features of a single previously disclosed embodiment.

Each patent, patent application, publication of a patent application, and other material cited herein, such as articles, books, specifications, publications, documents, articles, etc., may be incorporated herein by reference. The entire contents hereof are hereby incorporated by reference for all purposes, except any prosecution document history related thereto, any similar prosecution document history inconsistent or conflicting with the present disclosure, or any similar prosecution document history that has a limiting effect on the broadest scope of the claims. For example, in the event of any inconsistency or conflict between the descriptions, definitions and/or use of terms associated with any of the included materials in connection with the present disclosure, the use of the present terms in the present disclosure shall prevail.

Finally, it should be understood that the embodiments of the present disclosure disclosed herein are illustrations of the principles of the embodiments of the present disclosure. Other modified embodiments are within the scope of the present disclosure. The embodiments disclosed in the present disclosure are therefore intended to be exemplary only and not limiting. Those skilled in the art may adopt alternative configurations based on the embodiments in the present disclosure to realize the application in the present disclosure. As such, the embodiments of the present disclosure are not limited to those embodiments that are precisely described in the application.

## Claims

1. An acoustic module, comprising:
a base including a base sidewall, a base bottom wall, and a first sound guiding hole, wherein the base sidewall and the base bottom wall form a first accommodation cavity, and the first sound guiding hole penetrates the base bottom wall and communicates with the first accommodation cavity;
a first waterproof assembly disposed within the first accommodation cavity and covering the first sound guiding hole to prevent liquid from entering the first accommodation cavity through the first sound guiding hole; and
a first acoustic assembly including:
a first acoustic transducer disposed on a side of the first waterproof assembly away from the base bottom wall; and
a first circuit board disposed between the first acoustic transducer and the first waterproof assembly and mechanically connected to the first acoustic transducer.

2. The acoustic module of claim 1, wherein the first waterproof assembly includes:
a first waterproof membrane; and
a first buffer provided with a first center hole, wherein the first buffer abuts against an edge region of the first waterproof membrane.

3. The acoustic module of claim 1, wherein
the first waterproof assembly includes a first bonding surface and a second bonding surface;
the first bonding surface is adhesive, so that the first waterproof assembly can be adhered on a bottom wall surface of the first accommodation cavity after subjected to an external pressure; and
the second bonding surface is adhesive, so that the first waterproof assembly can be adhered to the first acoustic assembly when contacting the first acoustic assembly.

4. The acoustic module of claim 1, wherein
the first circuit board abuts against a top surface of the base sidewall;
the first circuit board includes a plurality of first positioning holes; and
the top surface of the base sidewall is provided with a plurality of first positioning projections in a one-to-one correspondence with the plurality of first positioning holes.

5. The acoustic module of claim 1, wherein
the first acoustic assembly further includes a reinforcement member, wherein the reinforcement member is disposed between the first circuit board and the first waterproof assembly, and abuts against the top surface of the base sidewall;
the reinforcement member includes a plurality of first positioning holes; and
the top surface of the base sidewall is provided with a plurality of first positioning projections in a one-to-one correspondence with the plurality of first positioning holes.

6. The acoustic module of claim 4 or claim 5, wherein
each of the plurality of first positioning projections includes a first column body and an expanded first column head, the first column body being threaded through a corresponding first positioning hole.

7. The acoustic module of claim 6, wherein the plurality of first positioning projections are a plurality of first thermally fused columns, the first column head being formed by deformation of a top portion of the first thermally fused column after being thermally fused.

8. The acoustic module of claim 1, wherein the base bottom wall is provided with a first limiting portion for coupling with a second limiting portion on an inner wall of an acoustic device when assembled to the acoustic device.

9. An acoustic device comprising:
the acoustic module of any one of claims 1-7; and
a housing assembly including:
a housing including a second accommodation cavity, a second sound guiding hole, a third accommodation cavity, and a third sound guiding hole, wherein the second sound guiding hole penetrates the housing and communicates with the second accommodation cavity, and the third sound guiding hole penetrates the housing and communicates with the third accommodation cavity;
a second waterproof assembly disposed within the third accommodation cavity, wherein the second waterproof assembly is sealed to the third accommodation cavity and covers the third sound guiding hole to prevent liquid from entering the third accommodation cavity through the third sound guiding hole; and
a second acoustic assembly including a second acoustic transducer, wherein the second acoustic assembly covers the third accommodation cavity and is disposed on a side of the second waterproof assembly away from the housing, and wherein the acoustic module is mounted within the second accommodation cavity, the base is sealed to the second accommodation cavity, and the first sound guiding hole communicates with the second sound guiding hole.

10. The acoustic device of claim 9, wherein
an inner wall of the housing forms a second accommodation sidewall and a second accommodation bottom wall of the second accommodation cavity; and
the second accommodation bottom wall includes a first step, wherein the first step divides the second accommodation bottom wall into a first bottom wall and a second bottom wall, and the second sound guiding hole penetrates the first bottom wall and communicates with the second accommodation cavity.

11. The acoustic device of claim 10, further comprising a first sealing member, wherein
the base abuts against the second bottom wall; and
a first gap is formed between the base and the first bottom wall, and the first sealing member is in the first gap and seals the first gap.

12. The acoustic device of claim 11, wherein
the base bottom wall is provided with a first limiting portion along a circumference of the first sound guiding hole, and
the first bottom wall is provided with a second limiting portion along a circumference of the second sound guiding hole, wherein the first limiting portion and the second limiting portion mate with and abut against each other.

13. The acoustic device of claim 12, wherein
the first sealing member is a fluid sealing material obtained by curing; and
the first limiting portion and the second limiting portion mate with and abut against each other to prevent the fluid sealing material from flowing into the second sound guiding hole.

14. The acoustic device of claim 12, wherein
the first limiting portion includes a groove disposed on the base bottom wall along the circumference of the first sound guiding hole; and
the second limiting portion includes a second step disposed on the first bottom wall disposed along the circumference of the second sound guiding hole.

15. The acoustic device of claim 12 or 14, wherein
the first limiting portion and the second limiting portion form a second gap, the second gap being sealed by the first sealing member.

16. The acoustic device of claim 9 or 11, wherein the base and the second accommodation cavity are sealedly connected by the first sealing member, the first sealing member being a preformed sealing gasket.

17. The acoustic device of claim 9, wherein
a hole diameter of the second sound guiding hole in an inner wall of the housing is smaller than a hole diameter of the second sound guiding hole in an outer wall of the housing; and/or
a hole diameter of the third sound guiding hole in the inner wall of the housing is smaller than a hole diameter of the third sound guiding hole in the outer wall of the housing.

18. The acoustic device of claim 9, wherein
a center axis of the second sound guiding hole is inclined relative to a second accommodation bottom wall of the second accommodation cavity; and/or
a center axis of the third sound guiding hole is inclined relative to a third accommodation bottom wall of the third accommodation cavity.

19. The acoustic device of claim 9, further comprising a second sealing member, wherein
an inner wall of the housing forms a second accommodation sidewall of the second accommodation cavity; and
a height of the second accommodation sidewall is higher than an upper surface of the first circuit board, thereby forming an accommodating space to accommodate the second sealing member.

20. The acoustic device of claim 19, wherein the second acoustic assembly includes a second circuit board, the first circuit board being connected to the second circuit board and passing over the second accommodation sidewall from a target section of the second accommodation sidewall, wherein
the first circuit board is a flexible circuit board; and
the target section of the second accommodation sidewall is designed more gentle compared with other portions of the second accommodation sidewall to reduce a bending degree of the first circuit board in the second accommodation sidewall.

21. The acoustic device of claim 20, wherein the target section includes a guiding opening and an inclined guiding surface on the second accommodation sidewall, the guiding opening being connected to the inner wall of the housing through the guiding surface to support the first circuit board.

22. The acoustic device of claim 9, wherein the second waterproof assembly includes:
a second waterproof membrane; and
a second buffer provided with a second center hole, wherein the second buffer abuts against an edge region of the second waterproof membrane.
